# EUROPÄISCHE PATENTSCHRIFT

(11) **EP 0 910 108 B1**
(45) Veröffentlichungstag und Bekanntmachung des Hinweises auf die Patenterteilung: **24.11.2004**
(21) Anmeldenummer: 97116909.9
(22) Anmeldetag: 29.09.1997
(51) Int. Cl.: H01J 37/141

(54) **Elektronenstrahl-Linse**
Electron beam lens
Lentille pour faisceau d'électrons

(43) Veröffentlichungstag der Anmeldung: 21.04.1999
(73) Patentinhaber: ADVANTEST CORPORATION, Shinjuku-ku, Tokyo 163-08 (JP)
(72) Erfinder: Frosien, Jürgen Dr., 85521 Riemerling (DE); Lanio, Stefan Dr., 85435 Erding (DE); Schönecker, Gerald Dr., 81549 München (DE)
(74) Vertreter: Tetzner, Volkmar, Dr.-Ing. Dr. jur.

(56) Entgegenhaltungen:
- EP-A- 0 133 016
- EP-A- 0 389 342
- GB-A- 2 018 509
- US-A- 4 419 581
- US-A- 5 644 132

## Beschreibung

Die Erfindung betrifft eine Elektronenstrahl-Linse, enthaltend eine Magnetlinse zur Beeinflussung eines Elektronenstrahls mit einem ersten und einem zweiten Polschuh, wobei sich ein Magnetfeld zwischen den beiden Polschuhen ausbildet und ferner ein dritter Polschuh vorgesehen ist. Die Erfindung bezieht sich ferner auf eine Kathodenlinse und eine Elektronenstrahlvorrichtung mit einer derartigen Elektronenstrahl-Linse.

Bei Korpuskularstrahl-Linsen ist man bestrebt, gute optische Eigenschaften für den Primärstrahl mit guten Sammeleigenschaften für die Sekundärstrahlen zu vereinbaren. Man ist dabei von konventionellen Zweipol-Linsen, bestehend aus einem inneren und einem äußeren Polschuh, ausgegangen, wobei das linsenerzeugende Magnetfeld sich weitgehend innerhalb der körperlichen Linse befindet. Man hat in diesem Zusammenhang auch Einzelpol-Linsen eingesetzt, bei denen ein Pol hervorgezogen bzw. der magnetfelderzeugende Luftspalt am oberen oder unteren Ende der Linse angeordnet ist, so daß sich das Magnetfeld weitgehend außerhalb des Linsenkörpers ausbreitet.

Aus der GB-A-2 018 509 ist eine Magnetlinse zur Beeinflussung eines Elektronenstrahls bekannt, die einen oberen und einen unteren Polschuh sowie einen driffen Polschuh aufweist der zwischen den beiden anderen Polschuhen angeordnet ist und nicht in magnetischem Kontakt mit diesen steht.

Aus der EP-A-0 133 016 ist eine Mehrpol-Linse bekannt, die im wesentlichen aus einer Aneinanderreihung von zwei Zweipol-Linsen der oben beschriebenen Art besteht.

Ausgehend von diesem Stand der Technik liegt nun der Erfindung die Aufgabe zugrunde, die Elektronenstrahl-Linse gemäß dem Oberbegriff des Anspruches 1 in ihren optischen Eigenschaften für den Primärstrahl und in ihren Sammeleigenschaften für die Sekundärstrahlen weiter zu verbessern.

Erfindungsgemäß wird diese Aufgabe durch die kennzeichnenden Merkmale des Anspruches 1 gelöst. Die Elektronenstrahl-Linse zeichnet sich dadurch aus, daß der dritte Polschuh in das zwischen dem ersten und zweiten Polschuh ausgebildete Magnetfeld eintaucht und dabei einen Teil dieses Magnetfeldes auskoppelt, wobei der ausgekoppelte Teil des Hauptmagnetfeldes am unteren Ende des dritten Polschuhs ein Nebenfeld ausbildet.

Der ausgekoppelte Teil des (Haupt-) Magnetfeldes bildet am unteren Ende des dritten Polschuhes ein zweites Linsenfeld (Nebenfeld) aus. Das Nebenfeld hat zum einen eine fokussierende Wirkung auf den Primärstrahl und aufgrund seiner Nähe zur Probe gute optische Eigenschaften und verhindert zum anderen, daß sich die Sekundärstrahlen aufweiten. Der Sekundärstrahl kann daher "gebündelt" ins Linsensystem eintreten und von einer Spektrometer/Detektor-Anordnung oder einem Detektor in oder oberhalb der Linse mit hoher Effizienz nachgewiesen werden.

In einem Ausführungsbeispiel der Erfindung wird die Elektronenstrahl-Linse vorteilhaft in einer Kathoden-Linse eingesetzt. Durch das vom dritten Polschuh erzeugte Nebenfeld wird erreicht, daß sich das positiv auswirkende Magnetfeld dicht an die Kathode heranführen läßt, ohne daß hierzu eine große körperliche Linse notwendig ist. Durch geeignetes Design der dreipoligen Magnet-Linse läßt sich die Stärke des Nebenfeldes an der Kathodenspitze und die optischen Eigenschaften der als Kondensor wirkenden ersten und zweiten Polschuhe getrennt optimieren.

In einem anderen Ausführungsbeispiel wird die Elektronenstrahl-Linse in einer Elektronenstrahl-Vorrichtung eingesetzt. Mit einem kippbaren Probenhalter können die Proben in bezug auf den Primärstrahl gekippt werden. Die spezielle Ausbildung der Elektronenstrahl-Linse ermöglicht bei kurzem Arbeitsabstand ein starkes Kippen bzw. bietet Raum für andere optionale Elemente wie Detektoren, Manipulatoren usw.

Weitere Ausgestaltungen der Erfindung sind Gegenstand der Unteransprüche und werden anhand der folgenden Beschreibung einiger Ausführungsbeispiele und der Zeichnung näher erläutert.

In der Zeichnung zeigen:
- Fig.1a: eine schematische Darstellung einer Elektronenstrahl-Linse gemäß einem ersten erfindungsgemäßen Ausführungsbeispiel;
- Fig.1b: Darstellung der Magnetfeldverteilung der Linse gemäß Fig.1a;
- Fig.2a: schematische Darstellung einer Elektronenstrahl-Linse gemäß dem Stand der Technik;
- Fig.2b: Darstellung der Magnetfeldverteilung der Linse gemäß Fig.2a;
- Fig.3: schematische Darstellung einer Elektronenstrahl-Linse gemäß einem zweiten erfindungsgemäßen Ausführungsbeispiel;
- Fig.4: schematische Darstellung einer Elektronenstrahl-Linse gemäß einem dritten erfindungsgemäßen Ausführungsbeispiel;
- Fig.5: schematische Darstellung einer Elektronenstrahl-Linse gemäß einem vierten erfindungsgemäßen Ausführungsbeispiel;
- Fig.6: geschnittene Darstellung des dritten Polschuhs gemäß einem fünften Ausführungsbeispiel;
- Fig.7: geschnittene Darstellung des dritten Polschuhs gemäß einem sechsten Ausführungsbeispiel;
- Fig.8: schematische Darstellung einer Kathoden-Linse mit einer erfindungsgemäßen Elektronenstrahl-Linse und
- Fig.9: schematische Darstellung einer Elektronenstrahl-Vorrichtung.

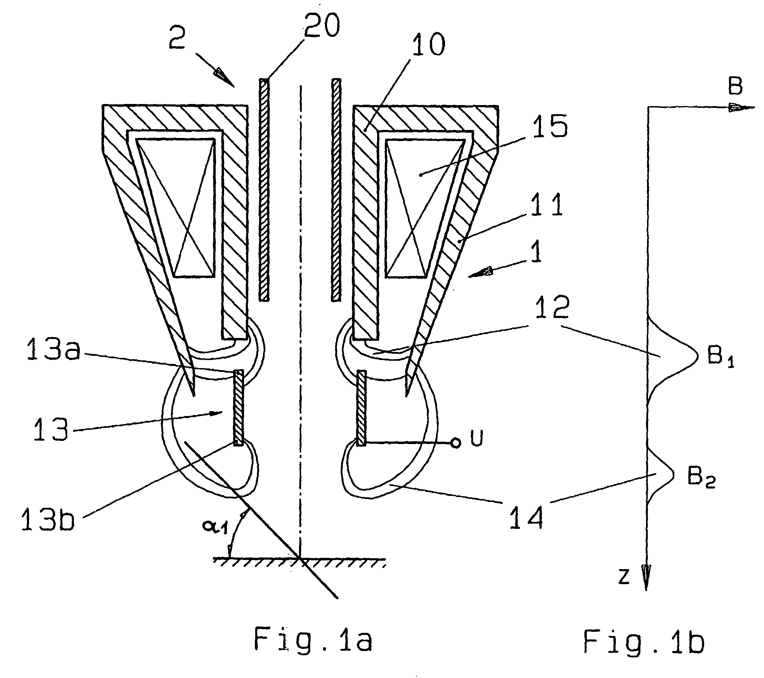

Die in Fig.1a dargestellte Elektronenstrahl-Linse weist eine Magnet-Linse 1 zur Beeinflussung eines Elektronenstrahls mit einem ersten, inneren Polschuh 10 und einem zweiten, äußeren Polschuh 11 auf. Der erste und zweite Polschuh 10, 11 sind im dargestellten Ausführungsbeispiel als Zweipol-Linse mit konisch ausgebildetem äußeren Polschuh 11 und einer Spule 15 dargestellt, wobei sich zwischen dem ersten und zweiten Polschuh ein magnetisches Hauptfeld 12 ausbildet.

Die Magnet-Linse 1 weist ferner einen dritten Polschuh 13 auf, der nicht in magnetischem Kontakt mit den beiden anderen Polschuhen steht und in das zwischen dem ersten und zweiten Polschuh 10, 11 ausgebildete Magnetfeld eintaucht. Der dritte Polschuh 13 ist vorzugsweise zylindrisch ausgebildet und taucht derart in das Hauptfeld 12 ein, daß ein Teil dieses Magnetfeldes ausgekoppelt wird.

Das am oberen Ende 13a des dritten Polschuhs 13 "aufgesaugte" Feld bildet im Bereich des unteren Endes 13b des dritten Polschuhs 13 ein magnetisches Nebenfeld 14. Ein Teil des Feldes des inneren Polschuhes 10 tritt somit in den dritten Polschuh 13 über und stellt am Ende 13b den Schluß zum äußeren Polschuh 11 unter Ausbildung des Nebenfeldes her.

In Fig.1b ist die Ausbreitung des Hauptfeldes 12 und des Nebenfeldes 14 dargestellt. Durch die Einführung des dritten Polschuhes 13 können zwei Linsenfelder in kurzem räumlichen Abstand geschaffen werden. Die Stärke des Nebenfeldes 14 hängt davon ab, wieweit der dritte Polschuh 13 in das Hauptfeld eintaucht und einen entsprechenden Anteil des Magnetfeldes auskoppelt und wie groß der Spalt zum inneren bzw. äußeren Polschuh 10, 11 ist. Zur Einstellung der Stärke des Nebenfeldes 14 wird der dritte Polschuh 13 zweckmäßigerweise in bezug auf den ersten und zweiten Polschuh 10, 11 verschiebbar bzw. verstellbar angeordnet.

Die Maxima der axialen Magnetfelder des Haupt- bzw. Nebenfeldes sind mit B₁ bzw. B₂ bezeichnet. Vorzugsweise ist der dritten Polschuh in bezug auf den ersten und zweiten Polschuh derart angeordnet, daß die Amplitude B₂ des Nebenfeldes wenigstens 15 %, vorzugsweise zwischen 20 % und 60 % der Amplitude B₁ des Hauptfeldes beträgt.

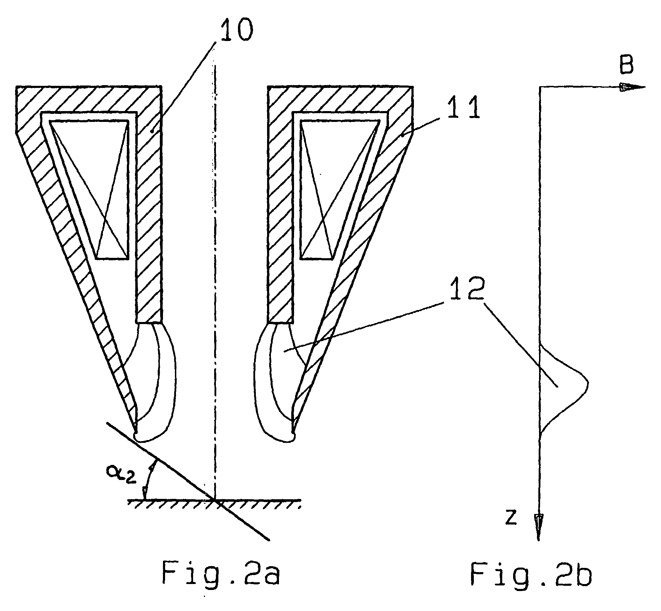

Zum Vergleich mit der in Fig.1a dargestellten "magnetischen Dreipol-Linse" zeigt Fig.2a eine herkömmliche Zweipol-Linse mit einem ersten und zweiten Pol 10, 11. Dementsprechend bildet sich auch nur ein Magnetfeld 12 aus, dessen Verteilung in Fig.2b dargestellt ist.

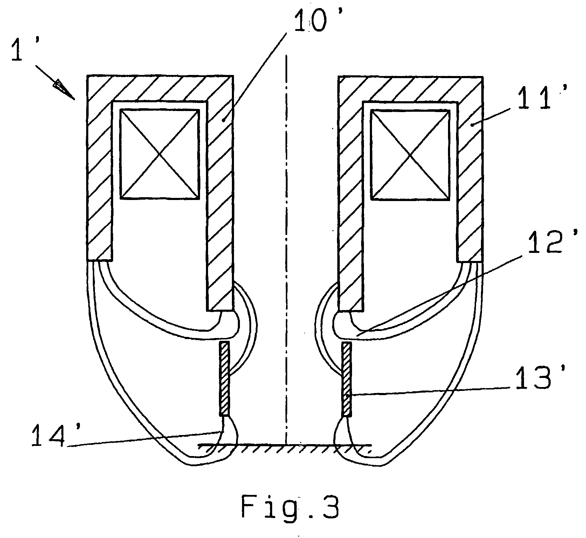

Fig.3 zeigt ein zweites erfindungsgemäßes Ausführungsbeispiel einer Elektronenstrahl-Linse, die sich vom Ausführungsbeispiel gemäß Fig.1a lediglich dadurch unterscheidet, daß der durch einen ersten Polschuh 10' und durch einen zweiten Polschuh 11' gebildete Teil der Magnet-Linse 1' als Einzelpol-Linse ausgebildet ist. Auch hier bildet sich jedoch ein Haupt- und ein Nebenfeld 12', 14'. Der Vorteil der Verwendung einer Einzelpol-Linse in Kombination mit einem dritten Polschuh 13' besteht vor allem darin, daß mit der Einzelpol-Linse ein besonders starkes Magnetfeld erzeugt und dementsprechend auch ein starker Teil als Nebenfeld 14' weitergegeben werden kann.

Die beiden in den Fig.1a und 3 dargestellten Elektronenstrahl-Linsen lassen sich vorteilhaft auch mit einer elektrostatischen Linse, insbesondere einer elektrostatischen Bremslinse kombinieren. Die elektrostatische Linse besteht aus wenigstens einer ersten und einer zweiten, mit unterschiedlichen Potentialen beaufschlagbaren Elektrode. In Fig.1a ist beispielhaft eine elektrostatische Linse 2 dargestellt, deren erste Elektrode aus einem Strahlrohr 20 besteht, das koaxial zum ersten Polschuh 10 im Inneren der Magnet-Linse 1 angeordnet ist. Die zweite Elektrode wird durch den dritten Polschuh 13 gebildet. Während das Strahlrohr 20 beispielsweise auf hohem positiven Potential liegt, könnte man am dritten Polschuh 13 eine geeignete, niedrigere positive oder negative Spannung U anlegen, um die gewünschte Bremswirkung auf den Elektronenstrahl zu erzeugen.

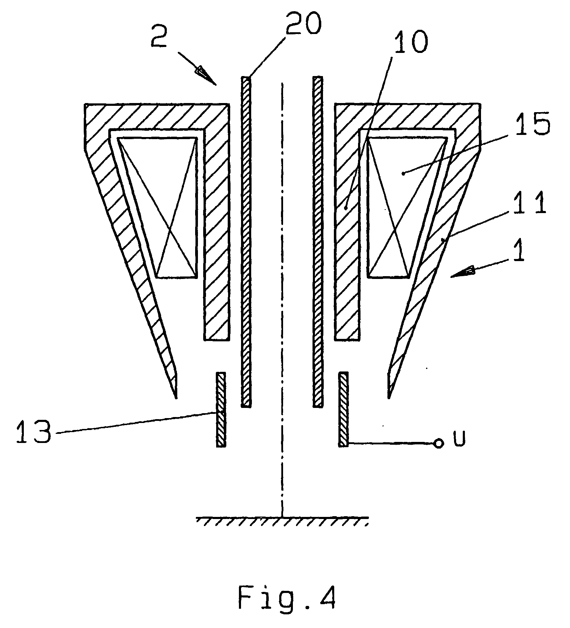

Für die Ausbildung der elektrostatischen Linse innerhalb der Elektronenstrahl-Linse gibt es verschiedene Möglichkeiten. In Fig.4 ist das Strahlrohr 20 weiter nach unten gezogen, so daß es in den dritten Polschuh 13 eintaucht. Die elektrostatische Linse bildet sich in diesem Fall im Bereich des eingetauchten Endes der ersten Elektrode 20 und der angrenzenden Wandung des dritten Polschuhs 13 aus.

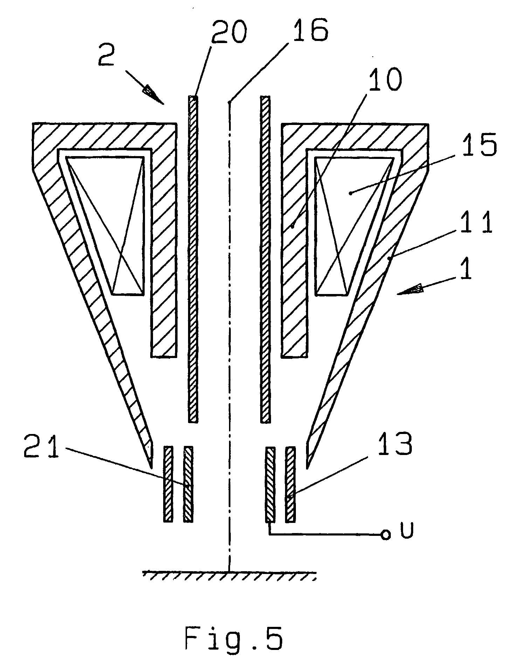

Im Ausführungsbeispiel gemäß Fig.5 wird die zweite Elektrode der elektrostatischen Linse 2 nicht durch den dritten Polschuh 13, sondern durch eine separate, in den Polschuh 13 eingeführte Rohrelektrode 21 gebildet. Im Rahmen der Erfindung wäre es auch denkbar, wenn diese Rohrelektrode 21 quer zur optischen Achse 16 ein oder mehrmals unterbrochen ist, um dadurch die elektrostatische Linse durch wenigstens drei Elektroden aufzubauen.

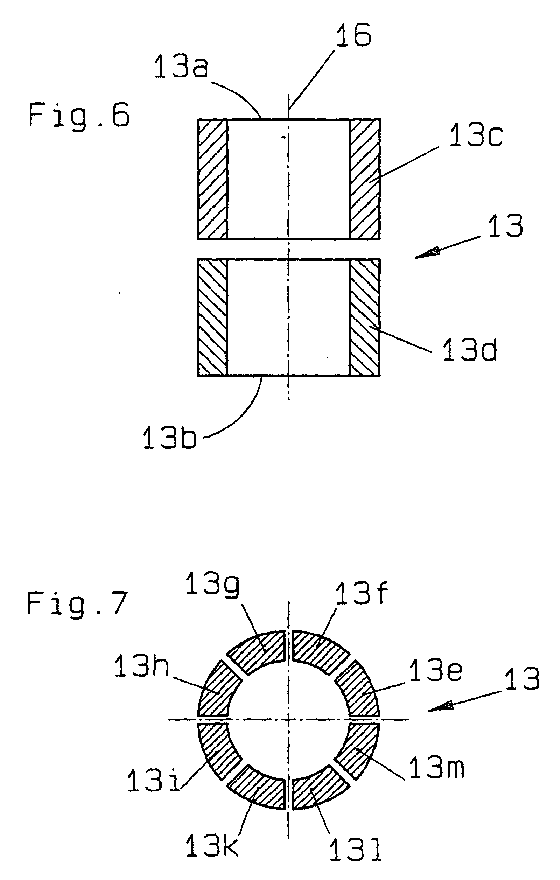

Fig.6 zeigt eine alternative Möglichkeit zum Aufbau der elektrostatischen Linse aus mehr als zwei Elektroden.

In diesem Ausführungsbeispiel bildet wiederum der dritte Polschuh 13 einen Teil der elektrostatischen Linse, wobei der Polschuh quer zur optischen Achse 16 in einen ersten Teil 13c und einen zweiten Teil 13d unterteilt ist. Diese beiden Teile 13c, 13d bilden die zweite und dritte Elektrode der elektrostatischen Linse und können für diesen Zweck mit unterschiedlichen Potentialen beaufschlagt werden.

Sofern man den Spalt zwischen den beiden Teilen 13c, 13d des dritten Polschuhs 13 möglichst klein wählt, wird das "aufgesaugte" Magnetfeld ungehindert vom oberen Ende 13a zum unteren Ende 13b geführt.

In Fig.7 ist ein Ausführungsbeispiel dargestellt, bei dem die zweite Elektrode der elektrostatischen Linse wiederum durch den dritten Polschuh gebildet wird. Dieser dritte Polschuh ist jedoch in Richtung der optischen Achse 16 geschlitzt ausgebildet, so daß sich im dargestellten Ausführungsbeispiel acht Segmente 13e, 13f, 13g, 13h, 13i, 13k, 13l, 13m bilden. Diese Segmente stellen elektrische Multipolelemente dar, die durch geeignetes Anlegen von Spannungen als elektrostatische Ablenker, Stigmator oder dergleichen geschaltet und verwendet werden können. Die einzelnen Spannungen werden dabei so gewählt, daß sich eine mittlere Spannung ergibt, die der Spannung U der zweiten Elektrode entspricht. Es ist aber auch ein geringere oder größere Anzahl an Segmenten denkbar.

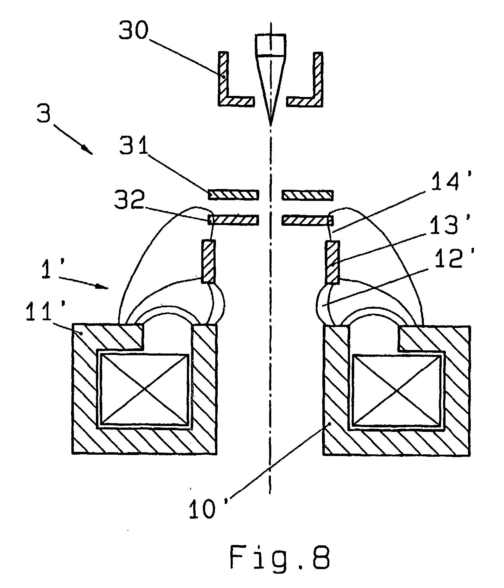

Fig.8 zeigt ein Anwendungsbeispiel der gezeigten Elektronenstrahl-Linsen in einer Kathoden-Linse 3. Die Kathoden-Linse 3 besteht im wesentlichen aus einer Kathode 30 mit "suppressor"-Elektrode, einer Extraktions-Elektrode 31, einer Anode 32 sowie einer Elektronenstrahl-Linse gemäß einem der beiden in den Fig.1a, 3 bis 7 gezeigten Ausführungsbeispiele. Hier wurde die Elektronenstrahl-Linse 1' gemäß Fig.3 ausgewählt. Die Elektronenstrahl-Linse wird so eingebaut, daß sich das ausbildende Nebenfeld 14' möglichst nahe an die Kathode 30 heranführen läßt und die durch die beiden Polschuhe 10', 11' gebildete Einzelpol-Linse als Kondensor wirkt.

Durch geeignetes Design der drei Polschuhe 10', 11', 13' lassen sich die Magnetfeldstärke des Nebenfeldes 14' an der Kathode und die optischen Eigenschaften des Hauptfeldes 12' getrennt voneinander optimieren.

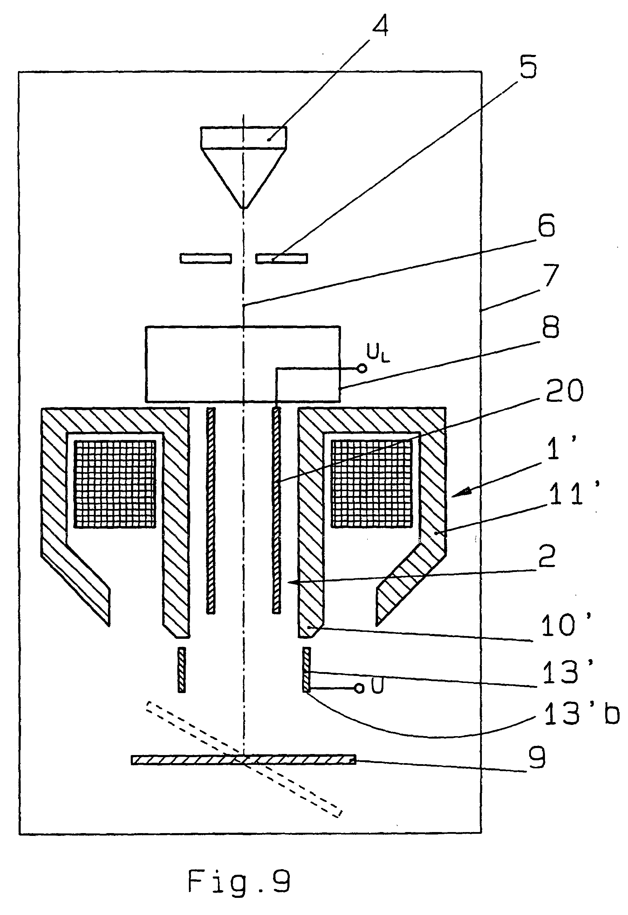

In Fig.9 ist schließlich eine Anwendung der Elektronenstrahl-Linse in einer Elektronenstrahl-Vorrichtung dargestellt. Die Elektronenstrahl-Vorrichtung wird durch eine optische Säule 7 gebildet, die im wesentlichen eine Quelle 4 zur Erzeugung eines Elektronenstrahls 6, eine Magnet-Linse 1' sowie eine Spektrometer/Detektor-Anordnung 8 aufweist. Neben einer Vielzahl von magnetischen und/oder elektrischen Linsen und Blenden zur Beeinflussung des Elektronenstrahls ist im Ausführungsbeispiel gemäß Fig.9 ferner noch ein Austastsystem 5 und ein kippbarer Probentisch 9 dargestellt.

Die hier verwendete Elektronenstrahl-Linse entspricht wiederum dem in Fig.3 dargestellten Ausführungsbeispiel, bei dem die beiden ersten Polschuhe 10', 11' eine Einzelpol-Linse bilden, die mit einem dritten Polschuh 13' kombiniert wird. Die elektrostatische Linse 2 wird wiederum durch ein in die Einzelpol-Linse eingeführtes Strahlrohr 20 als erste Elektrode und durch den unteren Teil des dritten Polschuhs 13' als zweite Elektrode gebildet. Das Strahlrohr 20 und der als zweite Elektrode dienende Teil des dritten Polschuhs 13' können mit unterschiedlichen Potentialen U_{L} bzw. U beaufschlagt werden.

Die dargestellte Spektrometer/Detektor-Anordnung 8 bzw. ein Detektor ist in Richtung des Elektronenstrahls 6 vor bzw. oberhalb der Magnetlinse 1' angeordnet. Es wäre jedoch auch denkbar, den Detektor innerhalb der Magnetlinse 1' vorzusehen. Die Detektoren können wahlweise einseitig, rotationssymmetrisch oder in segmentierter Form oder aber auch als kombinierte Rückstreu-/Sekundär-Elektronen-Detektoren ausgebildet sein. Aber auch eine Anordnung des Detektors zwischen Magnet-Linse und Probe wäre denkbar.

Das sich zwischen der auf dem Probentisch 9 angeordneten Probe und dem unteren Ende 13'b des dritten Polschuhs 13' ausbildende Nebenfeld hat zum einen eine fokussierende Wirkung auf den primären Elektronenstrahl und zum andern aufgrund seiner Nähe zur Probe gute optische Eigenschaften. Dieses Nebenfeld bewirkt zudem, daß sich die ausgelösten Sekundär-Elektronen nicht aufweiten, sondern vielmehr gebündelt in die Elektronenstrahl-Linse eintreten und von der Spektrometer/Detektor-Anordnung 8 mit hoher Effizienz nachgewiesen werden können.

Es ist durchaus denkbar, am dritten Polschuh 13' eine positive Absaugspannung anzulegen, wobei jedoch auch eine zusätzliche Elektrode verwendet werden kann. Vorteilhaft sind jedoch positive Absaugfelder mit Spannungen unterhalb von 100 V, da so die elektrische Aufladung von isolierenden Proben minimiert wird. Aber auch höhere elektrische Felder und damit eine kombiniert elektrisch/magnetische Linse sind denkbar und gegebenenfalls erstrebenswert.

Die Ausbildung der Magnetlinse 1' als Dreipol-Linse mit den drei Polschuhen 10', 11', 13' hat weiterhin den Vorteil, daß das untere Ende dieser Dreipol-Linse kleiner bzw. spitzer als bei herkömmlichen Zweipol-Linsen ausgebildet ist. Diese Ausbildung ist insbesondere bei kippbaren Probentischen von besonderem Vorteil, da hierdurch ein größerer Kippwinkel α erzielt werden kann. In diesem Zusammenhang sei nochmals auf die beiden Fig.1a und 2a verwiesen, die jeweils den maximalen Kippwinkel α₁ bzw. α₂ zeigen. Bei der erfindungsgemäßen Elektronenstrahl-Linse ist der maximale Kippwinkel α₁ größer als der Winkel α₂ beim Stand der Technik. Diese Eigenschaft ist insbesondere bei der Untersuchung von Proben mit sehr kurzem Arbeitsabstand hilfreich, da auch dann noch ein großer Kippwinkel zur Verfügung steht.

Sofern der Probentisch nicht kippbar ausgeführt ist, kann der zusätzlich zur Verfügung stehende Raum auch für optionale Elemente wie Detektoren, Manipulatoren usw. ausgenutzt werden.

## Patentansprüche

1. Elektronenstrahl-Linse enthaltend eine Magnetlinse (1; 1') zur Beeinflussung eines Elektronenstrahls (6) mit einem ersten und einem zweiten Polschuh (10, 11; 10', 11') wobei sich ein Hauptmagnetfeld (12) zwischen den beiden Polschuhen ausbildet und ferner ein dritter Polschuh (13; 13') vorgesehen ist, der nicht in magnetischem Kontakt mit den beiden anderen Polschuhen steht,
**dadurch gekennzeichnet, daß** der dritte Polschuh in das zwischen dem ersten und zweiten Polschuh ausgebildete Hauptmagnetfeld (12) eintaucht und einen Teil dieses Magnetfeldes auskoppelt, wobei der ausgekoppelte Teil des Hauptmagnetfeldes am unteren Ende des dritten Polschuhs ein Nebenfeld ausbildet.

2. Elektronenstrahl-Linse nach Anspruch 1, **dadurch gekennzeichnet, daß** der dritte Polschuh (13; 13') zylindrisch ausgebildet ist.

3. Elektronenstrahl-Linse nach Anspruch 1, **dadurch gekennzeichnet, daß** der dritte Polschuh (13; 13') relativ zum ersten und zweiten Polschuh (10, 11; 10', 11') verstellbar angeordnet ist.

4. Elektronenstrahl-Linse nach Anspruch 1, **dadurch gekennzeichnet, daß** der erste und zweite Polschuh (10, 11) als Zweipol-Linse ausgebildet ist.

5. Elektronenstrahl-Linse nach Anspruch 4, **dadurch gekennzeichnet, daß** die Zweipol-Linse konisch ausgebildet ist.

6. Elektronenstrahl-Linse nach Anspruch 1, **dadurch gekennzeichnet, daß** der erste und zweite Polschuh (10', 11') als Einzelpol-Linse ausgebildet ist.

7. Elektronenstrahl-Linse nach Anspruch 1, **dadurch gekennzeichnet, daß** innerhalb der Magnetlinse (1; 1') eine elektrostatische Linse (2) vorgesehen ist.

8. Elektronenstrahl-Linse nach Anspruch 7, **dadurch gekennzeichnet, daß** die elektrostatische Linse (2) als Bremslinse ausgebildet ist.

9. Elektronenstrahl-Linse nach Anspruch 7, **dadurch gekennzeichnet, daß** die elektrostatische Linse (2) wenigstens eine erste und eine zweite mit unterschiedlichen Potentialen beaufschlagbare Elektrode aufweist.

10. Elektronenstrahl-Linse nach Anspruch 7, **dadurch gekennzeichnet, daß** die elektrostatische Linse (2) wenigstens zwei Elektroden aufweist, wobei die eine Elektrode durch den dritten Polschuh (13; 13') gebildet wird.

11. Elektronenstrahl-Linse nach Anspruch 10, **dadurch gekennzeichnet, daß** der dritte Polschuh in Segmente aufgeteilt ist, die mit unterschiedlichen Potentialen beaufschlagbar sind.

12. Elektronenstrahl-Linse nach Anspruch 7, **dadurch gekennzeichnet, daß** die elektrostatische Linse (2) wenigstens zwei Elektroden aufweist, wobei die eine Elektrode durch ein in den durch den ersten und zweiten Polschuh (10, 11; 10', 11') gebildeten Teil der Magnetlinse (1; 1') als Strahlrohr (20) eingeführt ist.

13. Kathodenlinse (3) mit
- einer Kathode (30),
- einer Extraktions-Elektrode (31),
- einer Anode (32)
- und einer Elektronenstrahl-Linse gemäß einem der Ansprüche 1 bis 11.

14. Elektronenstrahl-Vorrichtung mit
- einer Quelle (4) zur Erzeugung eines Elektronenstrahls (6),
- einer Elektronenstrahl-Linse zur Fokussierung des Elektronenstrahls auf eine Probe gemäß einem der Ansprüche 1 bis 11.

15. Elektronenstrahl-Vorrichtung gemäß Anspruch 14, **dadurch gekennzeichnet, daß** ein kippbarer Probentisch (9) vorgesehen ist.

16. Elektronenstrahl-Vorrichtung gemäß Anspruch 14, **dadurch gekennzeichnet, daß** eine Spektrometer/Detektor-Anordnung zum Nachweis von an der Probe ausgelösten Sekundärteilchen vorgesehen ist.

## Claims

1. Electron beam lens which contains a magnetic lens (1; 1') for influencing an electron beam (6) and which has a first and a second pole piece (10, 11; 10', 11'), a primary magnetic field (12) being produced between the two pole pieces and a third pole piece (13; 13') additionally being provided which is not in magnetic contact with the other two pole pieces,
**characterised in that** the third pole piece is introduced into the primary magnetic field (12) which is produced between the first and second pole piece and decouples a portion of this magnetic field, the decoupled portion of the primary magnetic field producing a secondary field at the lower end of the third pole piece.

2. Electron beam lens according to claim 1, **characterised in that** the third pole piece (13; 13') is constructed in a cylindrical manner.

3. Electron beam lens according to claim 1, **characterised in that** the third pole piece (13; 13') is arranged so as to be adjustable relative to the first and second pole piece (10, 11, 10', 11').

4. Electron beam lens according to claim 1, **characterised in that** the first pole piece (10) and second pole piece (11) are constructed as a two-pole lens.

5. Electron beam lens according to claim 4, **characterised in that** the two-pole lens is constructed in a conical manner.

6. Electron beam lens according to claim 1, **characterised in that** the first pole piece (10') and second pole piece (11') are constructed as a single-pole lens.

7. Electron beam lens according to claim 1, **characterised in that** an electrostatic lens (2) is provided within the magnetic lens (1; 1').

8. Electron beam lens according to claim 7, **characterised in that** the electrostatic lens (2) is constructed as a retarding lens.

9. Electron beam lens according to claim 7, **characterised in that** the electrostatic lens (2) has at least a first and a second electrode which can be subjected to different potentials.

10. Electron beam lens according to claim 7, **characterised in that** the electrostatic lens (2) has at least two electrodes, one electrode being formed by the third pole piece (13; 13').

11. Electron beam lens according to claim 10, **characterised in that** the third pole piece is divided into segments which can be subjected to different potentials.

12. Electron beam lens according to claim 7, **characterised in that** the electrostatic lens (2) has at least two electrodes, one electrode being introduced as a beam tube (20) through a portion of the magnetic lens (1; 1'), which portion is formed by the first and second pole piece (10, 11; 10', 11').

13. Cathode lens (3) having
- a cathode (30),
- an extraction electrode (31),
- an anode (32)
- and an electron beam lens according to any one of claims 1 to 11.

14. Electron beam device having
- a source (4) for producing an electron beam (6),
- an electron beam lens for focusing the electron beam on a sample according to any one of claims 1 to 11.

15. Electron beam device according to claim 14, **characterised in that** a tiltable sample table (9) is provided.

16. Electron beam device according to claim 14, **characterised in that** a spectrometer/detector arrangement is provided in order to detect secondary particles which are released from the sample.

## Revendications

1. Lentille pour faisceau d'électrons, qui contient une lentille magnétique (1, 1') qui agit sur un faisceau d'électrons (6), avec une première et une deuxième pièces polaires (10, 11, 10', 11') entre lesquelles est formé un champ magnétique principal (12), une troisième pièce polaire (13, 13') qui n'est pas en contact magnétique avec les deux autres pièces polaires étant en outre prévue,
**caractérisée en ce que** la troisième pièce polaire se trouve dans le champ magnétique principal (12) situé entre la première et la deuxième pièces polaires et découple une partie de ce champ magnétique, la partie découplée du champ magnétique principal formant un champ secondaire à l'extrémité inférieure de la troisième pièce polaire.

2. Lentille pour faisceau d'électrons selon la revendication 1, **caractérisée en ce que** la troisième pièce polaire (13, 13') a une forme cylindrique.

3. Lentille pour faisceau d'électrons selon la revendication 1, **caractérisée en ce que** la troisième pièce polaire (13, 13') est agencée de manière à pouvoir être déplacée par rapport à la première et à la deuxième pièces polaires (10, 11, 10', 11').

4. Lentille pour faisceau d'électrons selon la revendication 1, **caractérisée en ce que** la première et la deuxième pièces polaires (10, 11) sont configurées comme lentille bipolaire.

5. Lentille pour faisceau d'électrons selon la revendication 1, **caractérisée en ce que** la lentille bipolaire est conique.

6. Lentille pour faisceau d'électrons selon la revendication 4, **caractérisée en ce que** la première et la deuxième pièces polaires (10', 11') sont configurées comme lentille unipolaire.

7. Lentille pour faisceau d'électrons selon la revendication 1, **caractérisée en ce qu'**une lentille électrostatique (2) est prévue à l'intérieur de la lentille magnétique (1, 1').

8. Lentille pour faisceau d'électrons selon la revendication 7, **caractérisée en ce que** la lentille électrostatique (2) est configurée comme lentille de freinage.

9. Lentille pour faisceau d'électrons selon la revendication 7, **caractérisée en ce que** la lentille électrostatique (2) présente au moins une première et une deuxième électrodes sur lesquelles on peut appliquer des potentiels différents.

10. Lentille pour faisceau d'électrons selon la revendication 7, **caractérisée en ce que** la lentille électrostatique (2) présente au moins deux électrodes dont l'une est formée par la troisième pièce polaire (13, 13').

11. Lentille pour faisceau d'électrons selon la revendication 10, **caractérisée en ce que** la troisième pièce polaire est divisée en segments sur lesquels ont peut appliquer des potentiels différents.

12. Lentille pour faisceau d'électrons selon la revendication 7, **caractérisée en ce que** la lentille électrostatique (2) présente au moins deux électrodes, l'une de ces électrodes étant introduite comme tube à faisceau (20) à travers une partie de la lentille magnétique (1, 1') formée par la première et la deuxième pièces polaires (10, 11, 10', 11').

13. Lentille de cathode, qui présente
une cathode (30),
une électrode d'extraction (31),
une anode (32)
et une lentille pour faisceau d'électrons selon l'une des revendications 1 à 11.

14. Dispositif à faisceau d'électrons qui présente une source (4) pour la production d'un faisceau d'électrons (6),
une lentille pour faisceau d'électrons, pour concentrer le faisceau d'électrons sur un échantillon, selon l'une des revendications 1 à 11.

15. Dispositif à faisceau d'électrons selon la revendication 14, **caractérisé en ce que** qu'un porte-échantillon basculant (9) est prévu.

16. Dispositif à faisceau d'électrons selon la revendication 14, **caractérisé en ce qu'**un agencement composé d'un détecteur et d'un spectromètre est prévu pour détecter les particules secondaires qui se dégagent de l'échantillon.
